# EUROPEAN PATENT APPLICATION

(11) **EP 4 435 871 A1**
(43) Date of publication of application: **25.09.2024**
(21) Application number: 23206297.6
(22) Date of filing: 27.10.2023
(51) Int. Cl.: H01L 29/775, H01L 21/336, H01L 21/8234, H01L 21/8238, H01L 29/423, B82Y 10/00, H01L 29/165, H01L 29/78

(54) **CONSTRAINED EPITAXIAL FORMATION USING DIELECTRIC WALLS**

(30) Priority: 24.03.2023 US 202318125880
(71) Applicant: INTEL Corporation, Santa Clara, CA 95054 (US)
(72) Inventor: Guler, Leonard, Hillsboro, 97124 (US); Glass, Glenn, Portland, 97229 (US); Panella, Jessica, Banks, 97106 (US); Lavric, Dan, Portland, 97229 (US); Wallace, Charles, Portland, 97212 (US)
(74) Representative: Goddar, Heinz J.

(57) **Abstract**

Techniques to form semiconductor devices having one or more epitaxial source or drain regions formed between dielectric walls that separate each adjacent pair of source or drain regions. In an example, a semiconductor device includes a semiconductor region extending in a first direction from a source or drain region. Dielectric walls extend in the first direction adjacent to opposite sides of the source or drain region. The first and second dielectric walls also extend in the first direction through a gate structure present over the semiconductor region. A dielectric liner exists between at least a portion of the first side of the source or drain region and the first dielectric wall and/or at least a portion of the second side of the source or drain region and the second dielectric wall. The dielectric walls may separate the source or drain region from other adjacent source or drain regions.

## Description

### FIELD OF THE DISCLOSURE

The present disclosure relates to integrated circuits, and more particularly, to the epitaxial region formation for transistor devices.

### BACKGROUND

As integrated circuits continue to scale downward in size, a number of challenges arise. For instance, reducing the size of memory and logic cells is becoming increasingly more difficult. Certain aspects of lithography technology can impose physical limits on how accurately certain structures can be aligned or producing tightly spaced elements. Due to the high complexity of integrated circuit layouts, any structures that require additional masking processes or tight alignment tolerances give rise to reduced yield, or possible points of failure for the device. Accordingly, there remain a number of non-trivial challenges with respect to forming such high-density semiconductor devices.

### BRIEF DESCRIPTION OF THE DRAWINGS

Figure 1A is an isometric view of an integrated circuit structure that includes source or drain regions formed between dielectric walls, in accordance with an embodiment of the present disclosure.
Figures 1B and 1C are cross-sectional views that illustrate a portion of a gate trench (1B) and a source/drain trench (1C) from Figure 1A, in accordance with an embodiment of the present disclosure.
Figures 2A and 2B are cross-sectional views that illustrate one stage in an example process for forming an integrated circuit configured with source or drain regions formed between dielectric walls, in accordance with an embodiment of the present disclosure.
Figures 3A and 3B are cross-sectional views that illustrate another stage in the example process for forming an integrated circuit configured with source or drain regions formed between dielectric walls, in accordance with an embodiment of the present disclosure.
Figures 4A and 4B are cross-sectional views that illustrate another stage in the example process for forming an integrated circuit configured with source or drain regions formed between dielectric walls, in accordance with an embodiment of the present disclosure.
Figures 5A and 5B are cross-sectional views that illustrate another stage in the example process for forming an integrated circuit configured with source or drain regions formed between dielectric walls, in accordance with an embodiment of the present disclosure.
Figures 6A and 6B are cross-sectional views that illustrate another stage in the example process for forming an integrated circuit configured with source or drain regions formed between dielectric walls, in accordance with an embodiment of the present disclosure.
Figures 7A and 7B are cross-sectional views that illustrate another stage in the example process for forming an integrated circuit configured with source or drain regions formed between dielectric walls, in accordance with an embodiment of the present disclosure.
Figures 8A and 8B are cross-sectional views that illustrate another stage in the example process for forming an integrated circuit configured with source or drain regions formed between dielectric walls, in accordance with an embodiment of the present disclosure.
Figures 9A and 9B are cross-sectional views that illustrate another stage in the example process for forming an integrated circuit configured with source or drain regions formed between dielectric walls, in accordance with an embodiment of the present disclosure.
Figures 10A and 10B are cross-sectional views that illustrate another stage in the example process for forming an integrated circuit configured with source or drain regions formed between dielectric walls, in accordance with an embodiment of the present disclosure.
Figures 11A and 11B are cross-sectional views that illustrate another stage in the example process for forming an integrated circuit configured with source or drain regions formed between dielectric walls, in accordance with an embodiment of the present disclosure.
Figures 12A and 12B are cross-sectional views that illustrate another stage in the example process for forming an integrated circuit configured with source or drain regions formed between dielectric walls, in accordance with an embodiment of the present disclosure.
Figure 13 illustrates a cross-section view of a chip package containing one or more semiconductor dies, in accordance with some embodiments of the present disclosure.
Figure 14 is a flowchart of a fabrication process for semiconductor device having source or drain regions formed between dielectric walls, in accordance with an embodiment of the present disclosure.
Figure 17 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are described herein to form semiconductor devices having one or more epitaxial source or drain regions formed between dielectric walls that separate each adjacent pair of source or drain regions. The techniques can be used in any number of integrated circuit applications and are particularly useful with respect to logic and memory cells, such as those cells that use finFETs or gate-all-around transistors. In an example, a semiconductor device includes a semiconductor region, such as one or more first nanoribbons, extending in a first direction from a source or drain region. A first dielectric wall extends in the first direction adjacent to a first side of the source or drain region, and a second dielectric wall extends in the first direction adjacent to a second side of the source or drain region with the second side being opposite to the first side. The first and second dielectric walls also extend in the first direction through a gate structure present over the semiconductor region. A dielectric liner exists between at least a portion of the first side of the source or drain region and the first dielectric wall and/or at least a portion of the second side of the source or drain region and the second dielectric wall. Each of the first and second dielectric walls may separate the source or drain region from other adjacent source or drain regions along a second direction orthogonal to the first direction. Numerous variations and embodiments will be apparent in light of this disclosure.

### General Overview

As previously noted above, there remain a number of non-trivial challenges with respect to epitaxial formation. Epitaxially grown source or drain regions may be formed adjacent to one another along a common source/drain trench that runs parallel to a gate trench. However, controlling the scaling between the source or drain regions can be challenging as the growth rate can be difficult to precisely control. Additionally, different regions may need to be grown at different times if they use differing dopant profiles (e.g., n-doped regions vs. p-doped regions).

Thus, and in accordance with an embodiment of the present disclosure, techniques are provided herein to form source or drain regions between previously-formed dielectric walls to create a natural separation between each pair of source or drain regions. Following the formation of semiconductor fins extending in a first direction that include semiconductor regions, source/drain trenches may be formed adjacent to gate trenches with both trenches running in a second direction orthogonal to the first direction. The source or drain trenches may then be filled with a sacrificial material to allow for gate processing and dielectric wall formation before the formation of the source or drain regions. Once gate structures have been formed within the gate trenches (e.g., after removing sacrificial gate material), one or more dielectric walls may be formed extending between adjacent fins and cutting through both the gate trenches and the source/drain trenches. Thus, according to some embodiments, the one or more dielectric walls extend in the first direction between devices and also extend in a third direction (e.g., Z-direction) through at least an entire thickness of the gate structures and through at least a portion of the sacrificial material within the source/drain trenches. With the dielectric walls in place, the sacrificial material in the source/drain trenches may be selectively removed in certain areas to form first source or drain regions in those areas. Sacrificial material may then be removed from other areas to form second source or drain regions in those other areas. Following the formation of the source or drain regions between dielectric walls, a dielectric liner can be formed over the exposed surfaces of the source or drain regions. This liner may form along sides of the source or drain regions between the source or drain regions and their adjacent dielectric walls. Since the dielectric walls were formed before the source or drain regions, portions of the dielectric liner may also be formed along the sidewalls of the dielectric walls.

According to an embodiment, an integrated circuit includes a semiconductor device having a semiconductor region extending in a first direction from a source or drain region, and a gate electrode extending in a second direction over the semiconductor region, a first dielectric wall extending in the first direction through the gate electrode and extending in the first direction adjacent to a first side of the source or drain region, a second dielectric wall extending in the first direction through the gate electrode and extending in the first direction adjacent to a second side of the source or drain region opposite from the first side of the source or drain region, and a dielectric liner on at least a portion of the first side of the source or drain region or the second side of the source or drain region and on at least a portion of a sidewall of the first dielectric wall and at least a portion of a sidewall of the second dielectric wall. The first and second semiconductor regions may include, for example, one or more nanoribbons, nanowires, or nanosheets.

According to another embodiment, an integrated circuit includes an electronic device having a chip package comprising one or more dies. At least one of the one or more dies includes a semiconductor device having a semiconductor region extending in a first direction from a first source or drain region to a second source or drain region, and a gate electrode extending in a second direction over the semiconductor region, a first dielectric wall extending in the first direction through the gate electrode and extending in the first direction adjacent to a first side of the first source or drain region and adjacent to a first side of the second source or drain region, a second dielectric wall extending in the first direction through the gate electrode and extending in the first direction adjacent to a second side of the first source or drain region opposite from the first side of the first source or drain region and adjacent to a second side of the second source or drain region opposite from the first side of the second source or drain region, a first dielectric liner on at least a portion of the first source or drain region, and a second dielectric liner on at least a portion of the second source or drain region.

According to another embodiment, an integrated circuit includes a first semiconductor device and a second semiconductor device. The first semiconductor device has a first semiconductor region extending in a first direction from a first source or drain region, and a first gate structure extending in a second direction over the first semiconductor region. The second semiconductor device has a second semiconductor region extending in the first direction from a second source or drain region, and a second gate structure extending in the second direction over the second semiconductor region. The first gate structure includes a first gate electrode and a first gate dielectric, and the second gate structure includes a second gate electrode and a second gate dielectric. The second source or drain region is adjacent to the first source or drain region along the second direction. The integrated circuit further includes a dielectric wall extending in the first direction between and contacting both the first gate electrode and the second gate electrode and extending in the first direction between the first source or drain region and the second source or drain region. A first dielectric liner is on at least a portion of the first source or drain region and on at least a portion of a first sidewall of the dielectric wall, and a second dielectric liner on at least a portion of the second source or drain region and on at least a portion of a second sidewall of the dielectric wall.

According to another embodiment, a method of forming an integrated circuit includes forming a fin comprising semiconductor material, the fin extending above a substrate and extending in a first direction; forming a sacrificial gate structure and spacer structures extending in a second direction over the fin, such that a portion of the fin are not covered by the sacrificial gate structure and spacer structures; forming a recess between adjacent spacer structures by removing the portion of the fin; forming a sacrificial material within the recess between the adjacent spacer structures; replacing the sacrificial gate with a gate structure; forming a first dielectric wall through an entire thickness of the gate structure and through an entire thickness of the sacrificial material, the first dielectric wall extending in the first direction adjacent to a first side of fin; forming a second dielectric wall through an entire thickness of the gate structure and through an entire thickness of the sacrificial material, the second dielectric wall extending in the first direction adjacent to a second side of fin opposite to the first side of the fin; removing the sacrificial material and forming a source or drain region from an exposed end of the semiconductor material within the recess; and forming a dielectric liner on the source or drain region, on a sidewall of the first dielectric wall, and on a sidewall of the second dielectric wall.

The techniques can be used with any type of non-planar transistors, including finFETs (sometimes called double-gate transistors, or tri-gate transistors), or nanowire, nanosheet, and nanoribbon transistors (sometimes called gate-all-around transistors), to name a few examples. The source and drain regions can be, for example, epitaxial regions that are deposited during an etch-and-replace source/drain forming process. The dopant-type in the source and drain regions will depend on the polarity of the corresponding transistor. The source and drain regions may be any epitaxial diffusion region. The gate structure can be implemented with a gate-first process or a gate-last process (sometimes called a remove metal gate, or RMG, process). Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate dielectric walls extending between each adjacent pair of source or drain regions where the dielectric walls also cut through the gate structure. Additionally, a dielectric liner may be observed between one or more sides of the source or drain regions and sidewalls of the adjacent dielectric walls. The dielectric liner may also be observed along sidewalls of the dielectric walls extending above the source or drain regions. Numerous configurations and variations will be apparent in light of this disclosure.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the materials has an element that is not in the other material.

### Architecture

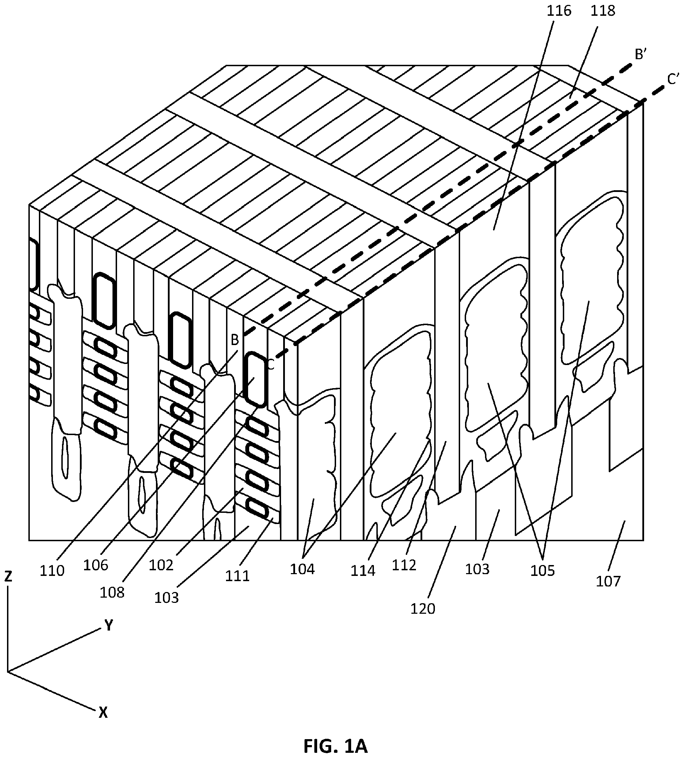

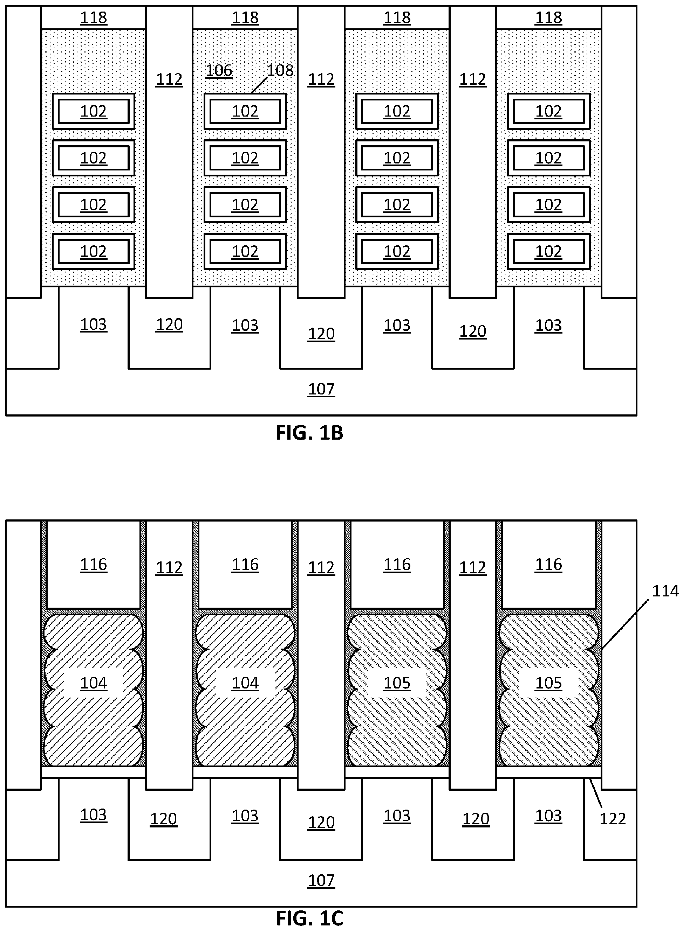

Figure 1 is an isometric view of a portion of an integrated circuit that includes various parallel semiconductor devices, in accordance with an embodiment of the present disclosure. Each of the semiconductor devices may be non-planar metal oxide semiconductor (MOS) transistors, such as tri-gate or gate-all-around transistors, although other transistor topologies and types could also benefit from the techniques provided herein. The examples herein illustrate semiconductor devices with a GAA structure (e.g., having nanoribbons, nanowires, or nanosheets that extend between source or drain regions).

Each semiconductor device includes one or more nanoribbons 102 extending between epitaxial source or drain regions 104 above subfin regions 103 in a first direction along the X-axis. Note that deeper devices along the Y-axis have nanoribbons that extend between source or drain regions 105 that may have a different dopant profile compared to source or drain regions 104, as discussed in more detail herein. A gate structure that includes a gate electrode 106 and a gate dielectric 108 extend over the one or more nanoribbons 102 in a second direction (e.g. along the Y-axis) to form the transistor gate. A given gate structure may extend over the semiconductor regions of more than one semiconductor device. It should be noted that the one or more nanoribbons 102 of each device may also be fins in trigate transistor designs.

According to some embodiments, subfin regions 103 are portions of the semiconductor fins that remain after formation of the various transistors and may be formed from a semiconductor substrate 107. Accordingly, subfin regions 103 may include the same semiconductor material as nanoribbons 102 and/or the underlying substrate.

The semiconductor material used in each of the semiconductor devices may be formed from semiconductor substrate 107. As noted above, the one or more semiconductor regions of the devices may include fins that can be, for example, native to substrate 107 (formed from the substrate itself), such as silicon fins etched from a bulk silicon substrate. Alternatively, the fins can be formed of material deposited onto the underlying substrate 107. In one such example case, a blanket layer of silicon germanium (SiGe) can be deposited onto a silicon substrate, and then patterned and etched to form a plurality of SiGe fins extending from that substrate. In still other embodiments, the fins include alternating layers of material (e.g., alternating layers of silicon and SiGe) that facilitates forming of nanowires and nanoribbons (such as the illustrated nanoribbons 102) during a gate forming process where one type of the alternating layers are selectively etched away so as to liberate the other type of alternating layers within the channel region, so that a gate-all-around process can then be carried out. Again, the alternating layers can be blanket deposited and then etched into fins or deposited into fin-shaped trenches. Substrate 107 may be later removed from the backside to form backside interconnects to source or drain regions 104/105 and/or gate electrode 106.

Source or drain regions 104/105 may be formed at the ends of the one or more nanoribbons 102 of each device, and thus may be aligned along the second direction from one another. According to some embodiments, source or drain regions 104/105 are epitaxial regions that are provided on the semiconductor regions in an etch-and-replace process. Any semiconductor materials suitable for source or drain regions can be used (e.g., group IV and group III-V semiconductor materials). Source or drain regions 104/105 may include multiple layers such as liners and capping layers to improve contact resistance. In any such cases, the composition and doping of source or drain regions 104 and 105 may be the same or different, depending on the polarity of the transistors. Any number of source or drain configurations and materials can be used. In some examples, source or drain regions 104 are formed at a different time compared to source or drain regions 105. For example, source or drain regions 104 may be n-doped or p-doped regions while source or drain regions 105 have the opposite dopant type.

As noted above, a gate structure extends in the second direction over the one or more nanoribbons 102 of various devices and includes both gate electrode 106 and gate dielectric 108. Gate electrode 106 may include any sufficiently conductive material such as a metal, metal alloy, or doped polysilicon. In some embodiments, gate electrode 106 includes one or more workfunction metals around the one or more semiconductor regions. In some embodiments, p-channel devices include a workfunction metal having titanium around its one or more semiconductor regions and n-channel devices include a workfunction metal having tungsten around its one or more semiconductor regions. Gate electrode 106 may also include a fill metal or other conductive material around the workfunction metals to provide the whole gate electrode structure. Gate dielectric 108 represents any number of dielectric layers that exist between the one or more nanoribbons 102 and gate electrode 106.

According to some embodiments, spacer structures 110 are present on the sidewalls of the gate structure and define a gate trench through which the gate structure is formed. Spacer structures 110 may include any suitable dielectric material such as silicon nitride or silicon oxynitride. In some embodiments, gate dielectric 108 also forms along sidewalls of spacer structures 110. Inner spacers 111 are present between adjacent nanoribbons 102 and may be the same dielectric material as spacer structures 110 (but formed at a later time as will be discussed in more detail herein).

According to some embodiments, one or more dielectric walls 112 extend across the gate structure in the first direction (e.g., parallel to the length of nanoribbons 102) and also extend across the source/drain trench to be between adjacent source or drain regions 104/105 within the source/drain trench. Dielectric walls 112 may continue to extend in the first direction across any number of other gate trenches and source/drain trenches to be between other adjacent source or drain regions in other source/drain trenches. According to some embodiments, one or more dielectric walls 112 includes any suitable dielectric material, such as silicon nitride, silicon oxide, or silicon oxynitride. One or more dielectric walls 112 may extend both above and below the height of source or drain regions 104. According to some embodiments, dielectric walls 112 extend at least through an entire thickness of the gate structures within the gate trenches. One or more dielectric walls 112 may include the same dielectric material as spacer structures 110.

According to some embodiments, a dielectric liner 114 is present on surfaces of source or drain regions 104/105. In some examples, dielectric liner 114 is on one or more side surfaces of source or drain regions 104/105, such that dielectric liner 114 is present between a given source or drain region 104/105 and the adjacent dielectric wall 112. According to some embodiments, dielectric liner 114 is present along the sidewalls of dielectric walls 112 extending above source or drain regions 104/105. Dielectric liner 114 may be any suitable dielectric material, such as silicon nitride or silicon oxynitride. In some examples, dielectric liner 114 is a low-k dielectric material (e.g., having a dielectric constant equal to or lower than that of silicon oxide, such as porous silicon oxide, or equal to or lower than 3.9).

A dielectric fill 116 may be provided over one or more of source or drain regions 104/105, according to some embodiments. Dielectric fill 116 may be any suitable dielectric material, such as silicon dioxide. In some examples, dielectric fill 116 may be replaced with a conductive material to form a topside conductive contact to the underlying source or drain region 104/105.

According to some embodiments, a gate cap 118 is provided over each gate structure (e.g., directly on a top surface of gate electrode 106). Gate cap 118 may be any suitable dielectric material, such as silicon dioxide, silicon nitride, or silicon oxynitride. A top surface of gate cap 118 may be polished to be substantially coplanar (e.g., within 2 nm) of a top surface of dielectric walls 112 and/or spacer structures 110.

According to some embodiments, a dielectric layer 120 extends across a bottom portion of the integrated circuit and between subfins 103 of each of the semiconductor devices, according to an embodiment. Dielectric layer 120 may include any suitable dielectric material such as silicon dioxide. Dielectric layer 120 provides shallow trench isolation (STI) between adjacent semiconductor devices, according to some embodiments.

Figures 1B and 1C illustrate cross-section views taken across the gate trench (Figure 1B) and source/drain trench (Figure 1C) along the YZ plane of Figure 1A, according to some embodiments. As can be seen along the gate trench and source/drain trenches in the cross-sections of Figures 1B and 1C, subfins 103 are below corresponding nanoribbons 102 and source or drain regions 104/105, along with dielectric layer 120 adjacent to subfins 103. Dielectric walls 112 extend into at least a portion of dielectric layer 120. In some embodiments, dielectric walls 112 extend through an entire thickness of dielectric layer 120 and may extend into a portion of substrate 107.

According to some embodiments, a lower dielectric region 122 may be provided between source or drain regions 104/105 and the underlying subfins 103. Lower dielectric region 122 may include any number of different dielectric materials and/or layers, such as silicon nitride, silicon dioxide, or silicon oxynitride, to name a few examples. In some embodiments, subfins 103 are recessed below a top surface of dielectric layer 120, such that lower dielectric region 122 is also formed within the recess and extends below the top surface of dielectric layer 120.

### Fabrication Methodology

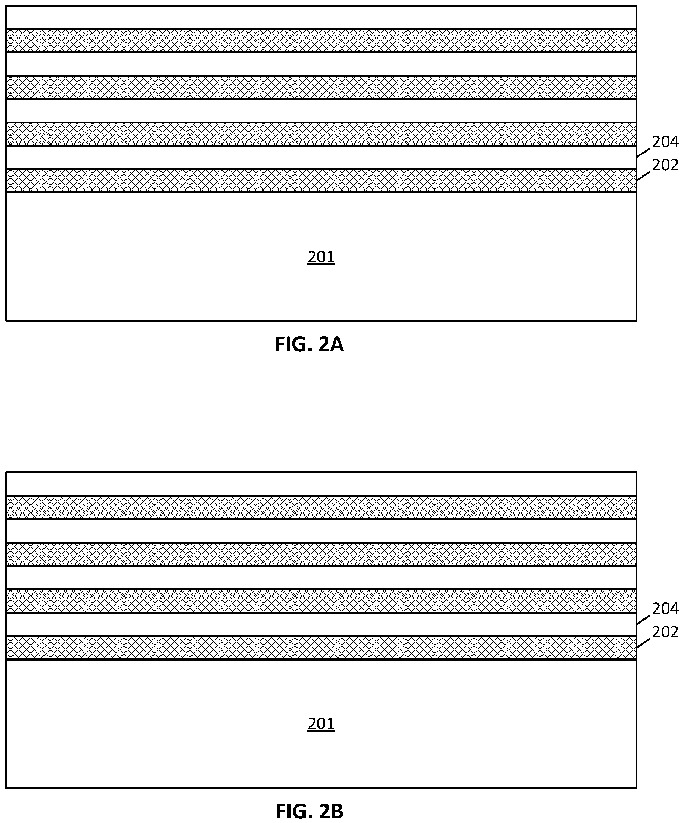

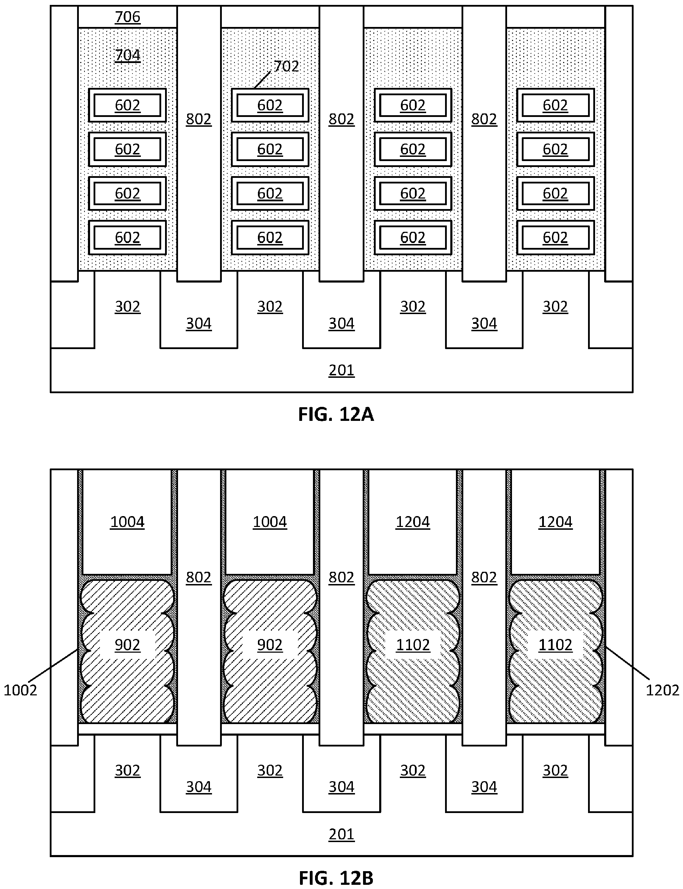

Figures 2A - 12A and 2B - 12B are cross-sectional views that collectively illustrate an example process for forming an integrated circuit configured with source or drain regions formed between dielectric walls, in accordance with an embodiment of the present disclosure. Figures 2A - 12A represent cross-sectional views taken across a gate trench of the integrated circuit, while figures 2B - 12B represent cross-sectional views taken across the source/drain trench adjacent to the gate trench along the same direction. Each figure shows an example structure that results from the process flow up to that point in time, so the depicted structure evolves as the process flow continues, culminating in the structure shown in Figures 12A and 12B, which is similar to the structure shown in Figures 1B and 1C, respectively. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but the present disclosure is not intended to be limited to any specific such materials or parameters, as will be appreciated. Figures sharing the same number (e.g., Figures 2A and 2B) illustrate different views of the structure at the same point in time during the process flow.

Figures 2A and 2B illustrate parallel cross-sectional views taken through a stack of alternating semiconductor layers on a semiconductor substrate 201. Figure 2A is taken across a portion of the stack that will eventually become a gate trench while Figure 2B is taken across a portion of the stack that will eventually become a source/drain trench adjacent and parallel to the gate trench. Alternating material layers may be deposited over substrate 201 including sacrificial layers 202 alternating with semiconductor layers 204. The alternating layers are used to form GAA transistor structures. Any number of alternating semiconductor layers 204 and sacrificial layers 202 may be deposited over substrate 201.

Substrate 201 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 201 can be a semiconductor-on-insulator substrate having a desired semiconductor layer over a buried insulator layer (e.g., silicon over silicon dioxide). Alternatively, substrate 201 can be a multilayer substrate or superlattice suitable for forming nanowires or nanoribbons (e.g., alternating layers of silicon and SiGe, or alternating layers indium gallium arsenide and indium phosphide). Any number of substrates can be used.

According to some embodiments, sacrificial layers 202 have a different material composition than semiconductor layers 204. In some embodiments, sacrificial layers 202 are silicon germanium (SiGe) while semiconductor layers 204 include a semiconductor material suitable for use as a nanoribbon such as silicon (Si), SiGe, germanium, or III-V materials like indium phosphide (InP) or gallium arsenide (GaAs). In examples where SiGe is used in each of sacrificial layers 202 and in semiconductor layers 204, the germanium concentration is different between sacrificial layers 202 and semiconductor layers 204. For example, sacrificial layers 202 may include a higher germanium content compared to semiconductor layers 204. In some examples, semiconductor layers 204 may be doped with either n-type dopants (to produce a p-channel transistor) or p-type dopants (to produce an n-channel transistor).

While dimensions can vary from one example embodiment to the next, the thickness of each sacrificial layer 202 may be between about 5 nm and about 20 nm. In some embodiments, the thickness of each sacrificial layer 202 is substantially the same (e.g., within 1-2 nm). The thickness of each of semiconductor layers 204 may be about the same as the thickness of each sacrificial layer 202 (e.g., about 5-20 nm). Each of sacrificial layers 202 and semiconductor layers 204 may be deposited using any known or proprietary material deposition technique, such as chemical vapor deposition (CVD), plasma-enhanced chemical vapor deposition (PECVD), physical vapor deposition (PVD), or atomic layer deposition (ALD).

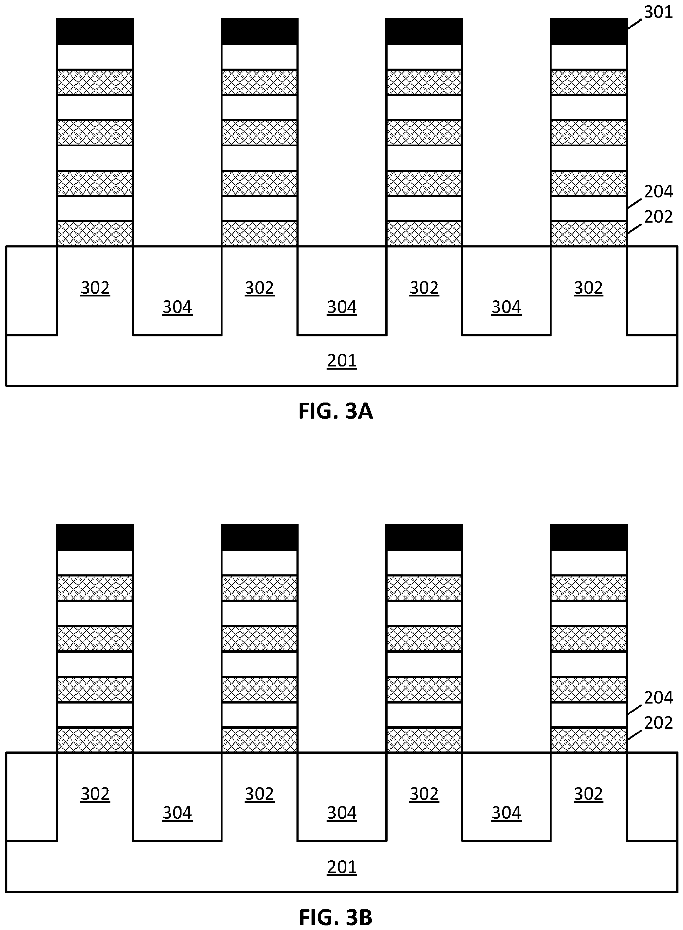

Figures 3A and 3B depict the cross-section views of the structure shown in Figures 2A and 2B, respectively, following the formation of a cap layer 301 and the subsequent formation of fins beneath cap layer 301, according to an embodiment. Cap layer 301 may be any suitable hard mask material such as a carbon hard mask (CHM) or silicon nitride. Cap layer 301 is patterned into rows to form corresponding rows of fins from the alternating layer stack of sacrificial layers 202 and semiconductor layers 204. The rows of fins extend lengthwise in a first direction (e.g., into and out of the page of each cross-section view).

According to some embodiments, an anisotropic etching process through the layer stack continues into at least a portion of substrate 201, where the unetched portions of substrate 201 beneath the fins form subfin regions 302. The etched portions of substrate 201 may be filled with a dielectric fill 304 that acts as shallow trench isolation (STI) between adjacent fins. Dielectric fill 304 may be any suitable dielectric material such as silicon oxide, and may be recessed to a desired depth as shown (in this example case, down to around the upper surface of subfin regions 302), so as to define the active portion of the fins that will be covered by a gate structure.

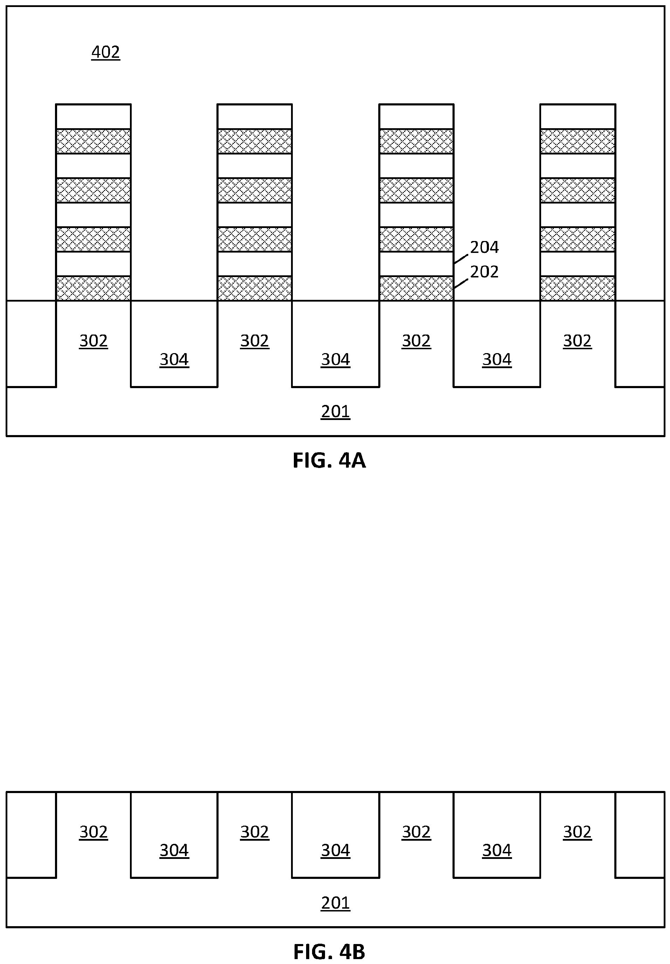

Figures 4A and 4B depict the cross-section views of the structure shown in Figures 3A and 3B, respectively, following the formation of a sacrificial gate 402 extending across the fins in a second direction different from the first direction, according to some embodiments. Sacrificial gate 402 may extend across the fins in a second direction that is orthogonal to the first direction. According to some embodiments, the sacrificial gate material is formed in parallel strips across the integrated circuit and removed in all areas not protected by a gate masking layer. Sacrificial gate 402 may be any suitable material that can be selectively removed without damaging the semiconductor material of the fins. In some examples, sacrificial gate 402 includes polysilicon.

As seen in the cross-section views, sacrificial gate 402 extends across the fins along the gate trench cross-section of Figure 4A but is not present along the source/drain trench cross-section of Figure 4B. Accordingly, sacrificial gate 402 (along with any gate spacers formed on the sidewalls of sacrificial gate 402) protect the underlying portions of the fins while the exposed portions of the fins are etched away as seen in Figure 4B. According to some embodiments, both semiconductor layers 204 and sacrificial layers 202 are etched at substantially the same rate using an anisotropic RIE process. As observed in Figure 4B, the fins are completely removed above subfin regions 302. In some embodiments, the RIE process may also etch into subfin regions 302 thus recessing subfin regions 302 beneath a top surface of dielectric fill 304.

According to some embodiments, the exposed portions of sacrificial layers 202 along the edges of the gate spacers may be recessed and the recessed can be filled with internal spacer material. The internal spacer material may be conformally deposited over the exposed ends of the fins and then etched back to fill the recesses with internal spacers and expose the ends of semiconductor layers 204.

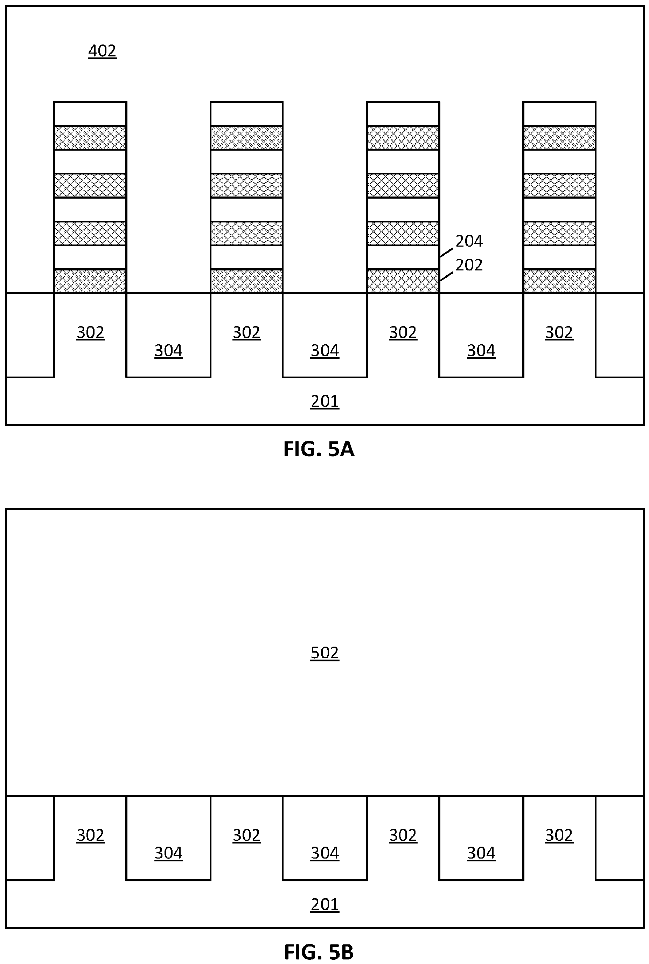

Figures 5A and 5B depict the cross-section views of the structure shown in Figures 4A and 4B, respectively, following the formation of sacrificial material 502 within the source/drain trench, according to some embodiments. According to some embodiments, the source/drain trench is filled with sacrificial material 502 over top surfaces of subfin regions 302 and/or dielectric fill 304. Sacrificial material 502 may be any suitable material that can be easily removed at a later time without damaging any surrounding structures. In some examples, sacrificial material 502 includes titanium nitride. After deposition of sacrificial material 502, it may be polished using chemical mechanical polishing (CMP) until a top surface of sacrificial material 502 is substantially coplanar with a top surface of sacrificial gate 402 and/or any spacer structures adjacent to sacrificial gate 402.

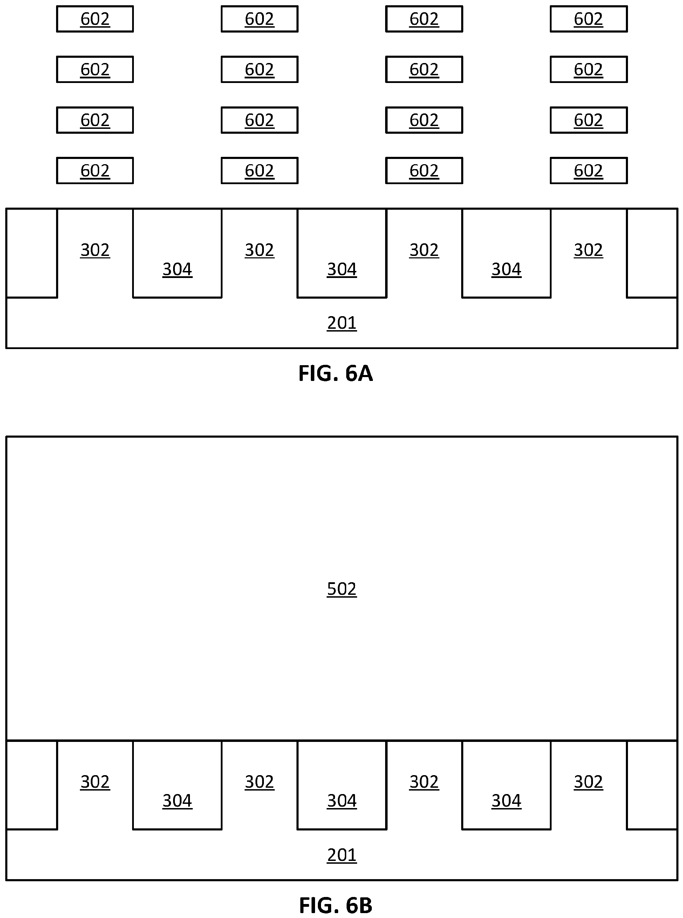

Figures 6A and 6B depict the cross-section views of the structure shown in Figures 5A and 5B, respectively, following the formation of nanoribbons 602 from semiconductor layers 204, according to some embodiments. Depending on the dimensions of the structures, nanoribbons 602 may also be considered nanowires or nanosheets. Sacrificial gate 402 may be removed using any wet or dry isotropic process thus exposing the alternating layer stack of the fins within the trenches left behind after the removal of sacrificial gate 402. Once sacrificial gate 402 is removed, sacrificial layers 202 may also be removed using a selective isotropic etching process that removes the material of sacrificial layers 202 but does not remove (or removes very little of) semiconductor layers 204 or any other exposed layers (e.g., inner gate spacers). Sacrificial gate 402 and sacrificial layers 202 may be removed together using the same isotropic etching process. At this point, the suspended (sometimes called released) semiconductor layers 204 form nanoribbons 602 that extend in the first direction (into and out of the page) between sacrificial material 502 within the source/drain trench on either side of the gate trench.

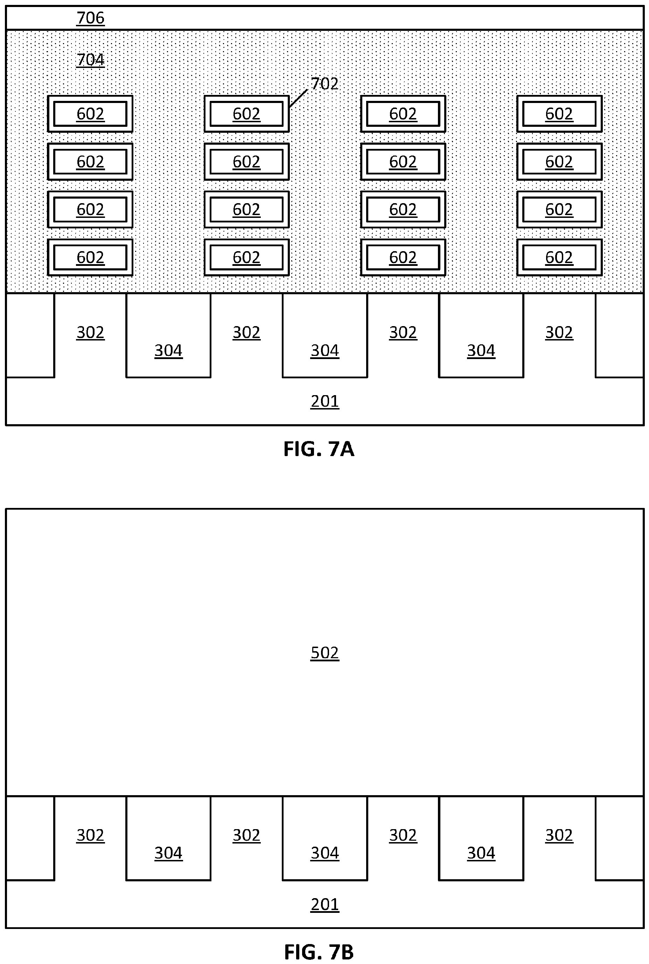

Figures 7A and 7B depict the cross-section views of the structure shown in Figures 6A and 6B, respectively, following the formation of a gate structure around nanoribbons 602 within the gate trench, according to some embodiments. As noted above, the gate structure includes a gate dielectric 702 and a gate electrode 704. Gate dielectric 702 may be conformally deposited around nanoribbons 602 using any suitable deposition process, such as atomic layer deposition (ALD). Gate dielectric 702 may include any suitable dielectric (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, gate dielectric 702 is hafnium oxide with a thickness between about 1 nm and about 5 nm. In some embodiments, gate dielectric 702 may include one or more silicates (e.g., titanium silicate, tungsten silicate, niobium silicate, and silicates of other transition metals). Gate dielectric 702 may be a multilayer structure, in some examples. For instance, gate dielectric 702 may include a first layer on nanoribbons 602, and a second layer on the first layer. The first layer can be, for instance, an oxide of the semiconductor layers (e.g., silicon dioxide) and the second layer can be a high-k dielectric material (e.g., hafnium oxide). In some embodiments, an annealing process may be carried out on gate dielectric 702 to improve its quality when a high-k dielectric material is used. In some embodiments, the high-k material can be nitridized to improve its aging resistance.

Gate electrode 704 may be deposited over gate dielectric 702 and can be any standard or proprietary conductive structure. In some embodiments, gate electrode 704 includes doped polysilicon, a metal, or a metal alloy. Example suitable metals or metal alloys include aluminum, tungsten, cobalt, molybdenum, ruthenium, titanium, tantalum, copper, and carbides and nitrides thereof. Gate electrode 704 may include, for instance, one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates.

According to some embodiments, a portion of gate electrode 704 may be recessed below a top surface of the adjacent spacer structures, and a gate cap 706 may be formed within the recessed area. Gate cap 706 may be any suitable dielectric material directly on a top surface of gate electrode 704. In some embodiments, a top surface of gate cap 706 is polished to be substantially coplanar with a top surface of sacrificial material 502.

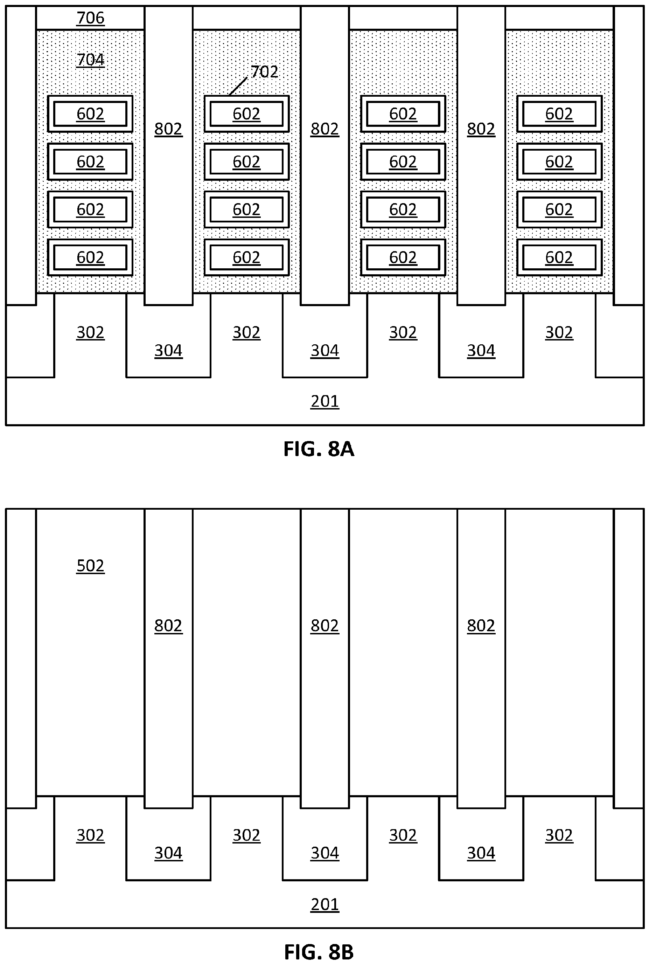

Figures 8A and 8B depict the cross-section views of the structure shown in Figures 7A and 7B, respectively, following the formation of dielectric walls 802, according to some embodiments. Dielectric walls 802 act like gate cuts through the gate structure to form isolated gate electrodes 704 for each semiconductor device. Dielectric walls 802 further extend along the first direction through sacrificial material 502 within the source/drain trench. Dielectric walls 802 may be formed by first forming trench-like high-aspect ratio recesses through a thickness of the gate structure and into at least a portion of dielectric fill 304, according to some embodiments. A metal gate etch process may be used that iteratively etches through portions of gate electrode 704 while simultaneously protecting the sidewalls of the recess from lateral etching to provide a high height-to-width aspect ratio (e.g., aspect ratio of 5:1 or higher, or 10:1 or higher). The recesses extend in the first direction to also cut through sacrificial material 502 within the source/drain trench. The recesses may extend through an entire thickness of sacrificial material 502. In some embodiments, the recesses extend through an entire thickness of dielectric fill 304.

According to some embodiments, the recesses are filled with one or more dielectric materials to form dielectric walls 802. Dielectric walls 802 may include only silicon dioxide or silicon nitride or silicon carbide. In some examples, dielectric walls 802 include a first dielectric layer deposited first and a second dielectric layer or dielectric fill formed on the first dielectric layer. The first dielectric layer may include a high-k dielectric material (e.g., materials with a dielectric constant higher than that of silicon oxide or higher than 3.9) while the second dielectric layer may include a low-k dielectric material (e.g. materials with a dielectric constant equal to or lower than that of silicon oxide, such as porous silicon oxide, or equal to or lower than 3.9). Since dielectric walls 802 are formed after the formation of the gate structure, gate dielectric 702 is not present along any sidewall of dielectric walls 802 within the gate trench. Due to the depth of the etched trenches, dielectric walls 802 extend at least below a full thickness of sacrificial material 502. Dielectric walls 802 may have a greatest width in the second direction (e.g. along a top surface) between about 5 nm and about 30 nm. The width of dielectric walls 1002 may taper down as the dielectric walls 802 extend deeper towards substrate 201 due to the fabrication process.

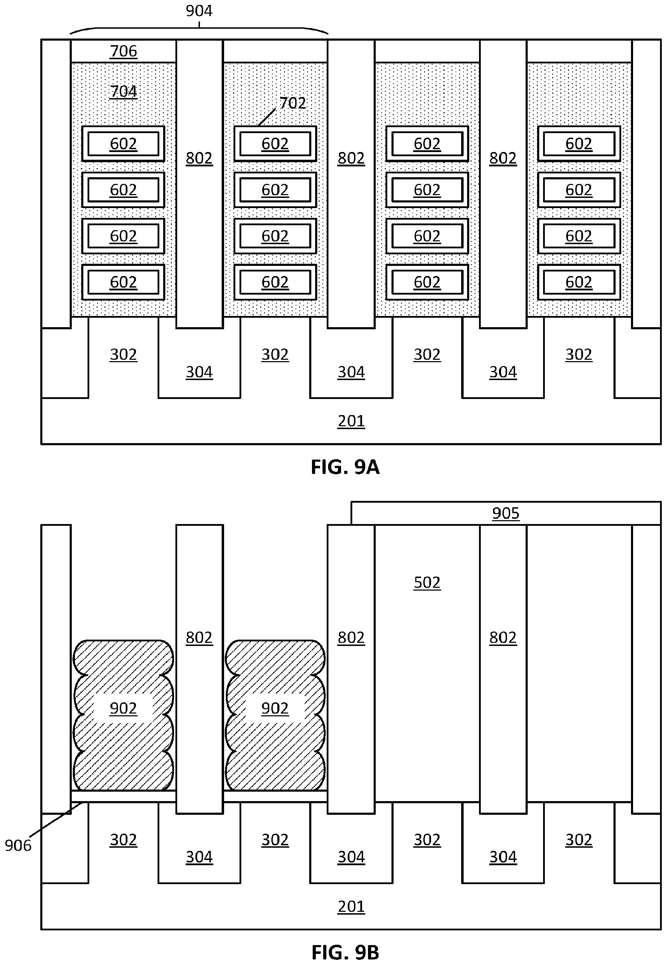

Figures 9A and 9B depict the cross-section views of the structure shown in Figures 8A and 8B, respectively, following the selective formation of first source or drain regions 902 at the ends of each of a first set of devices 904 (extending into and out of the page in Figure 9A), according to some embodiments. A mask layer 905 may be used to protect certain regions of sacrificial material 502 while exposing other regions of sacrificial material 502. Mask layer 905 may be any suitable hard mark material or photoresist. The exposed sacrificial material 502 may be removed using any suitable isotropic etching process followed by the formation of a lower dielectric region 906 over the exposed subfin regions 302. Lower dielectric region 906 may include any number of dielectric materials and/or layers, such as silicon nitride, silicon dioxide, or silicon oxynitride.

First source or drain regions 902 may be epitaxially grown from the exposed ends of nanoribbons 602 from first set of devices 904, such that epitaxial growth on one nanoribbon 602 can fully or partially merge with epitaxial growth on one or more other nanoribbons 602 in the same vertical stack. The degree of any such merging can vary from one embodiment to the next. In the example of PMOS devices, first source or drain regions 902 may be a semiconductor material (e.g., group IV or group III-V semiconductor materials) having a higher dopant concentration of p-type dopants compared to n-type dopants. In the example of NMOS devices, first source or drain regions 902 may be a semiconductor material (e.g., group IV or group III-V semiconductor materials) having a higher dopant concentration of n-type dopants compared to p-type dopants. According to some embodiments, the various first source or drain regions 902 grown from different semiconductor devices may be aligned along the second direction as shown in Figure 9B. First source or drain regions 902 may be formed directly on lower dielectric region 906. It should be noted that first set of devices 904 do not need to be directly adjacent to one another, as illustrated, and may be individually arranged anywhere within the integrated circuit.

Due to the presence of dielectric walls 802, first source or drain regions 902 grow within their own wells isolated from one another. In some embodiments, first source or drain regions 902 do not contact the sidewalls of dielectric walls 802.

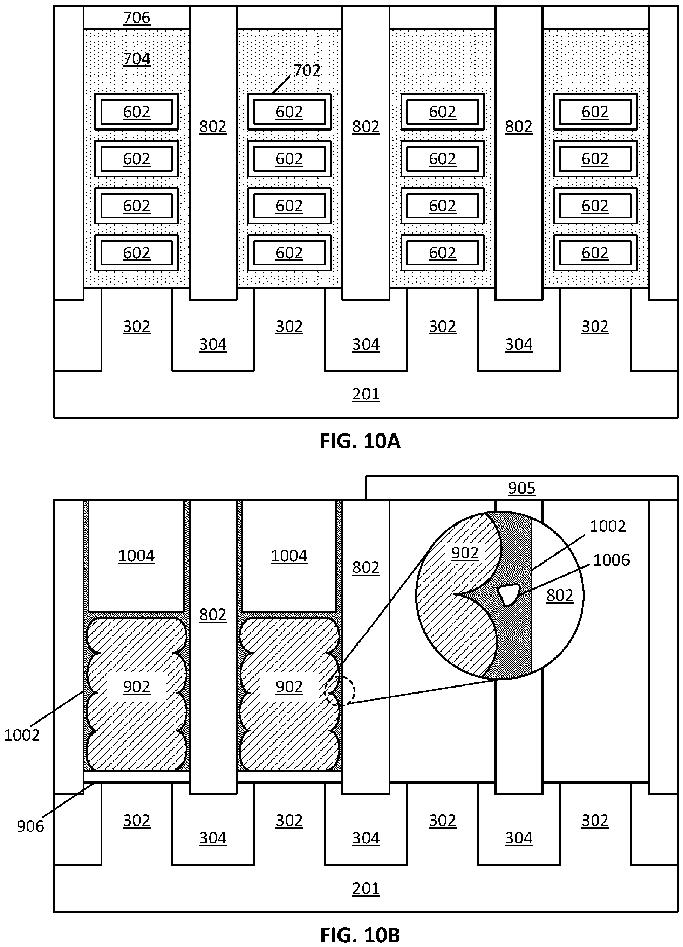

Figures 10A and 10B depict the cross-section views of the structure shown in Figures 9A and 9B, respectively, following the formation of a dielectric liner 1002 on first source or drain regions 902 and a dielectric fill 1004 over first source or drain regions 902, according to some embodiments. Dielectric liner 1002 may be deposited using any suitable conformal deposition technique such as CVD, PECVD, or ALD to form at least on the exposed top surfaces of first source or drain regions 902. According to some embodiments, dielectric liner 1002 also forms along one or more side surfaces of first source or drain regions 902 such that dielectric liner 1002 forms between first source or drain regions 902 and the adjacent dielectric walls 802. Due to the deposition process, dielectric liner 1002 also forms along any exposed sidewalls of dielectric walls 802, such as portions of the sidewalls that extend above first source or drain regions 902.

According to some embodiments, one or more voids 1006 may form within dielectric liner 1002 due to the proximity between first source or drain regions 902 and dielectric walls 802 as seen in the magnified view. One or more inert gases may be trapped within voids 1006, or any gas present within the chamber during the deposition of dielectric liner 1002. Voids 1006 may be primarily located between the side surfaces of first source or drain regions 902 and the sidewalls of dielectric walls 802.

According to some embodiments, dielectric fill 1004 may be provided over first source or drain regions 902 to fill a reminding volume of the source/drain trench above first source or drain regions 902. Dielectric fill 1004 may be any suitable dielectric material, although in some embodiments, dielectric fill 1004 includes the same dielectric material as dielectric fill 304. In one example, both dielectric fill 1004 and dielectric fill 304 include silicon dioxide. According to some embodiments, a top surface of dielectric fill 1004 may be polished using, for example, CMP. The top surface of dielectric fill 1004 may be polished until it is substantially coplanar with a top surface of gate cap 706 and/or a top surface of dielectric walls 802.

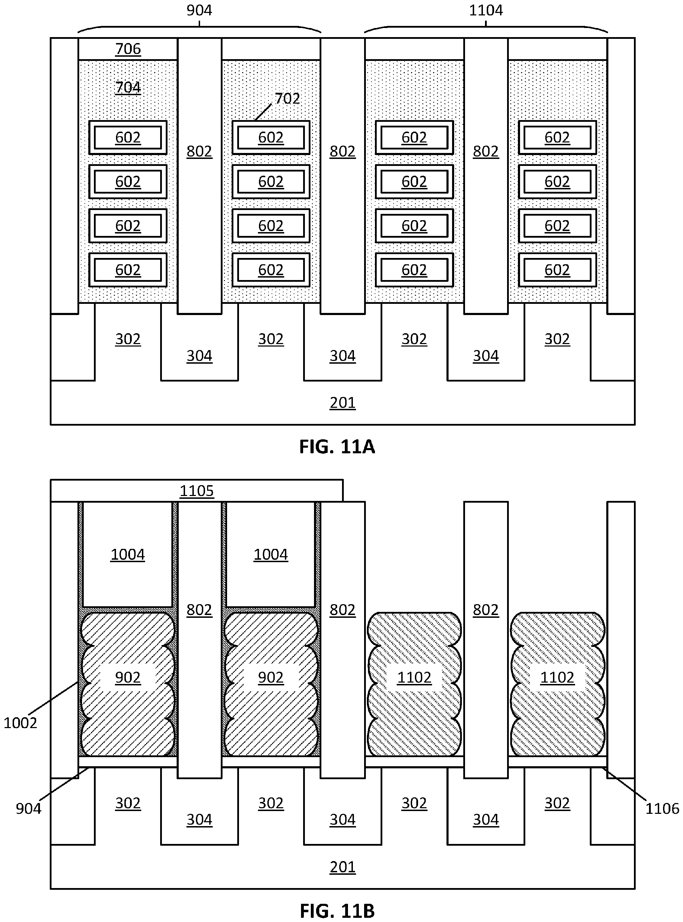

Figures 11A and 11B depict the cross-section views of the structure shown in Figures 10A and 10B, respectively, following the selective formation of second source or drain regions 1102 at the ends of each of a second set of devices 1104 (extending into and out of the page in Figure 11A) different from first set of devices 904, according to some embodiments. A mask layer 1105 may be used to expose additional regions of sacrificial material 502 while protecting previously formed source or drain regions. Mask layer 1105 may be any suitable hard mark material or photoresist. The exposed sacrificial material 502 may be removed using any suitable isotropic etching process followed by the formation of a lower dielectric region 1106 that may be similar to lower dielectric region 906.

Second source or drain regions 1102 may be epitaxially grown from the exposed ends of nanoribbons 602 from second set of devices 1104, such that epitaxial growth on one nanoribbon 602 can fully or partially merge with epitaxial growth on one or more other nanoribbons 602 in the same vertical stack. The degree of any such merging can vary from one embodiment to the next. In the example of PMOS devices, second source or drain regions 1102 may be a semiconductor material (e.g., group IV or group III-V semiconductor materials) having a higher dopant concentration of p-type dopants compared to n-type dopants. In the example of NMOS devices, second source or drain regions 1102 may be a semiconductor material (e.g., group IV or group III-V semiconductor materials) having a higher dopant concentration of n-type dopants compared to p-type dopants. According to some embodiments, the various second source or drain regions 1102 grown from different semiconductor devices may be aligned along the second direction as shown in Figure 9B. Second source or drain regions 1102 may be formed directly on lower dielectric region 1106. It should be noted that second set of devices 1104 do not need to be directly adjacent to one another, as illustrated, and may be individually arranged anywhere within the integrated circuit. According to some embodiments, first source or drain regions 902 have the opposite dopant type (e.g., n-type or p-type) compared to second source or drain regions 1102.

Due to the presence of dielectric walls 802, second source or drain regions 1102 grow within their own wells isolated from one another. In some embodiments, second source or drain regions 1102 do not contact the sidewalls of dielectric walls 802.

Figures 12A and 12B depict the cross-section views of the structure shown in Figures 11A and 11B, respectively, following the formation of a dielectric liner 1202 on second source or drain regions 1102 and a dielectric fill 1204 over second source or drain regions 1102, according to some embodiments. Dielectric liner 1202 may be deposited using any suitable conformal deposition technique such as CVD, PECVD, or ALD to form at least on the exposed top surfaces of second source or drain regions 1102. According to some embodiments, dielectric liner 1202 also forms along one or more side surfaces of second source or drain regions 1102 such that dielectric liner 1202 forms between second source or drain regions 1102 and the adjacent dielectric walls 802. Due to the deposition process, dielectric liner 1202 also forms along any exposed sidewalls of dielectric walls 802, such as portions of the sidewalls that extend above second source or drain regions 1102. Voids may form within dielectric liner 1202 in the same fashion as discussed above for dielectric liner 1002.

According to some embodiments, dielectric fill 1204 may be provided over second source or drain regions 1102 to fill a reminding volume of the source/drain trench above second source or drain regions 1102. Dielectric fill 1204 may be any suitable dielectric material, although in some embodiments, dielectric fill 1204 includes the same dielectric material as dielectric fill 1004. According to some embodiments, a top surface of dielectric fill 1204 may be polished until it is substantially coplanar with a top surface of gate cap 706 and/or a top surface of dielectric walls 802. It should be understood that any of dielectric fill 1004 or dielectric fill 1204 may be removed and replaced with conductive material to form topside conductive contacts to the corresponding source or drain region 902/1102.

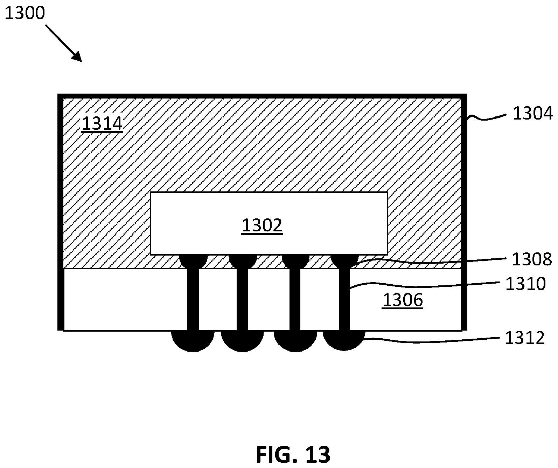

Figure 13 illustrates an example embodiment of a chip package 1300. As can be seen, chip package 1300 includes one or more dies 1302. One or more dies 1302 may include at least one integrated circuit having semiconductor devices, such as any of the semiconductor devices disclosed herein. One or more dies 1302 may include any other circuitry used to interface with other devices formed on the dies, or other devices connected to chip package 1300, in some example configurations.

As can be further seen, chip package 1300 includes a housing 1304 that is bonded to a package substrate 1306. The housing 1304 may be any standard or proprietary housing, and provides, for example, electromagnetic shielding and environmental protection for the components of chip package 1300. The one or more dies 1302 may be conductively coupled to a package substrate 1306 using connections 1308, which may be implemented with any number of standard or proprietary connection mechanisms, such as solder bumps, ball grid array (BGA), pins, or wire bonds, to name a few examples. Package substrate 1306 may be any standard or proprietary package substrate, but in some cases includes a dielectric material having conductive pathways (e.g., including conductive vias and lines) extending through the dielectric material between the faces of package substrate 1306, or between different locations on each face. In some embodiments, package substrate 1306 may have a thickness less than 1 millimeter (e.g., between 0.1 millimeters and 0.5 millimeters), although any number of package geometries can be used. Additional conductive contacts 1312 may be disposed at an opposite face of package substrate 1306 for conductively contacting, for instance, a printed circuit board (PCB). One or more vias 1310 extend through a thickness of package substrate 1306 to provide conductive pathways between one or more of connections 1308 to one or more of contacts 1312. Vias 1310 are illustrated as single straight columns through package substrate 1306 for ease of illustration, although other configurations can be used (e.g., damascene, dual damascene, through-silicon via). In still other embodiments, vias 1310 are fabricated by multiple smaller stacked vias, or are staggered at different locations across package substrate 1306. In the illustrated embodiment, contacts 1312 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 1312, to inhibit shorting.

In some embodiments, a mold material 1314 may be disposed around the one or more dies 1302 included within housing 1304 (e.g., between dies 1302 and package substrate 1306 as an underfill material, as well as between dies 1302 and housing 1304 as an overfill material). Although the dimensions and qualities of the mold material 1314 can vary from one embodiment to the next, in some embodiments, a thickness of mold material 1314 is less than 1 millimeter. Example materials that may be used for mold material 1314 include epoxy mold materials, as suitable. In some cases, the mold material 1314 is thermally conductive, in addition to being electrically insulating.

### Methodology

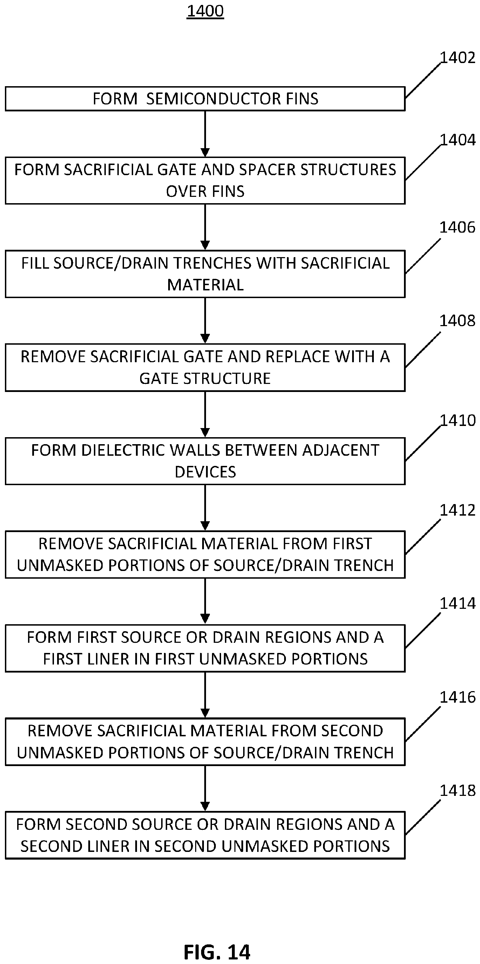

Figure 14 is a flow chart of a method 1400 for forming at least a portion of an integrated circuit, according to an embodiment. Various operations of method 1400 may be illustrated in Figures 2A - 12A and 2B - 12B. However, the correlation of the various operations of method 1400 to the specific components illustrated in the aforementioned figures is not intended to imply any structural and/or use limitations. Rather, the aforementioned figures provide one example embodiment of method 1400. Other operations may be performed before, during, or after any of the operations of method 1400. Some of the operations of method 1400 may be performed in a different order than the illustrated order.

Method 1400 begins with operation 1402 where a plurality of parallel semiconductor fins are formed, according to some embodiments. The semiconductor material in the fins may be formed from a substrate such that the fins are an integral part of the substrate (e.g., etched from a bulk silicon substrate). Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, the fins include alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around (GAA) process can then be carried out. The alternating layers can be blanket deposited and then etched into fins, or deposited into fin-shaped trenches. The fins may also include a cap structure over each fin that is used to define the locations of the fins during, for example, an RIE process. The cap structure may be a dielectric material, such as silicon nitride.

According to some embodiments, a dielectric fill is formed around subfin portions of the one or more fins. In some embodiments, the dielectric fill extends between each pair of adjacent parallel fins and runs lengthwise in the same direction as the fins. In some embodiments, the anisotropic etching process that forms the fins also etches into a portion of the substrate and the dielectric fill may be formed within the recessed portions of the substrate. Accordingly, the dielectric fill acts as shallow trench isolation (STI) between adjacent fins. The dielectric fill may be any suitable dielectric material, such as silicon oxide.

Method 1400 continues with operation 1404 where a sacrificial gate and spacer structures are formed over the fins. The sacrificial gate may be patterned using a gate masking layer in a strip that runs orthogonally over the fins (many gate masking layers and corresponding sacrificial gates may be formed parallel to one another (e.g., forming a crosshatch pattern with the fins). The gate masking layer may be any suitable hard mask material, such as CHM or silicon nitride. The sacrificial gate may be formed from any suitable material that can be selectively removed at a later time without damaging the semiconductor material of the fins. In one example, the sacrificial gate includes polysilicon. The spacer structures may be deposited and then etched back such that the spacer structures remain mostly only on sidewalls of any exposed structures, such as on sidewalls of the sacrificial gate. According to some embodiments, the spacer structures may be any suitable dielectric material, such as silicon nitride or silicon oxynitride.

Method 1400 continues with operation 1406 where at least a portion of the source/drain trenches is filled with sacrificial material. Any portions of the fins not protected by the sacrificial gate and spacer structures may be removed using, for example, an anisotropic etching process. According to some embodiments, the subfin portions of the fins may be further recessed below a top surface of the adjacent dielectric fill. A sacrificial material may then be deposited using any suitable deposition technique (CVD, PECVD, etc.) within the source/drain trenches and on the substrate. The sacrificial material may fill the source/drain trenches such that a top surface of the sacrificial material is substantially coplanar with a top surface of the sacrificial gate and spacer structures. The sacrificial material may be titanium nitride or aluminum nitride.

Method 1400 continues with operation 1408 where the sacrificial gate is removed and replaced with a gate structure. The sacrificial gate may be removed using an isotropic etching process that selectively removes all of the material from the sacrificial gate, thus exposing the various fins between the set of spacer structures. In the example case where GAA transistors are used, any sacrificial layers within the exposed fins between the spacer structures may also be removed to release nanoribbons, nanosheets, or nanowires of semiconductor material.

The gate structure may include both a gate dielectric and a gate electrode. The gate dielectric is first formed over the exposed semiconductor regions between the spacer structures followed by forming the gate electrode within the remainder of the trench between the spacer structures, according to some embodiments. The gate dielectric may include any number of dielectric layers deposited using a CVD process, such as ALD. The gate electrode can include any number of conductive material layers, such as any metals, metal alloys, or polysilicon. The gate electrode may be deposited using electroplating, electroless plating, CVD, ALD, PECVD, or PVD, to name a few examples.

Method 1400 continues with operation 1410 where dielectric walls are formed between adjacent pairs of devices. Deep recesses are first formed through at least a full thickness of the gate structure and extending into the source/drain trenches through the sacrificial material. The deep recesses may be formed using a metal gate etch process that iteratively etches through portions of the gate electrode while simultaneously protecting the sidewalls of the recess from lateral etching to provide a high height-to-width aspect ratio (e.g., aspect ratio of 5:1 or higher, or 10:1 or higher). According to some embodiments, the recesses also extend through an entire thickness of the dielectric fill adjacent to the subfin portions of the fins.

The deep recesses are filled with one or more dielectric materials to form the dielectric walls. For example, the dielectric material may include only silicon dioxide or silicon nitride. In some examples, the dielectric material includes a first dielectric layer and a second dielectric layer on the first dielectric layer within a remaining volume of the deep recesses. The first dielectric layer may include a high-k dielectric material (e.g. materials with a dielectric constant higher than that of silicon oxide or higher than 3.9) while the second dielectric layer may include a low-k dielectric material (e.g. materials with a dielectric constant equal to or lower than that of silicon oxide or equal to or lower than 3.9).

Method 1400 continues with operation 1412 where sacrificial material is removed from selected portions of the source/drain trench between adjacent pairs of dielectric walls. A mask material may be used to protect the sacrificial material in other portions of the source/drain trench. The mask material may be a dielectric hard mask or a photoresist. The exposed sacrificial material may be removed using any suitable isotropic etching process to expose the ends of the semiconductor regions along the edges of the source/drain trench. In some embodiments, a lower dielectric region is formed at the bottom of the portions of the source/drain trench where the sacrificial material is removed. The lower dielectric region can include any number of dielectric materials and/or layers and may be provided to isolate the eventual source or drain regions from any portion of the underlying substrate and/or subfin portions.

Method 1400 continues with operation 1414 where first source or drain regions are formed at the ends of the exposed semiconductor regions in the portions of the source/drain trenches where the sacrificial material is removed. Epitaxial growth of the first source or drain regions may occur from the exposed ends of the semiconductor layers. In some example embodiments, the first source or drain regions are NMOS source or drain regions (e.g., epitaxial silicon) or PMOS source or drain regions (e.g., epitaxial SiGe).

According to some embodiments, a first dielectric liner is formed on the first source or drain regions. The first dielectric liner may be deposited using any suitable conformal deposition technique such as CVD, PECVD, or ALD to form at least on the exposed top surfaces of the first source or drain regions. According to some embodiments, the first dielectric liner also forms along one or more side surfaces of the first source or drain regions such that the first dielectric liner forms between the first source or drain regions and the adjacent dielectric walls within the source/drain trench. Due to the deposition process, the first dielectric liner may also form along any exposed sidewalls of the dielectric walls, such as portions of the sidewalls that extend above the first source or drain regions. The first dielectric liner may be any suitable dielectric material, such as silicon nitride. According to some embodiments, some voids may be present within the first dielectric liner between sides of the first source or drain regions and the adjacent dielectric walls.

According to some embodiments, a first dielectric fill may be formed over any of the first source or drain regions within the source/drain trench. In some instances, the first dielectric fill acts as a placeholder and may be later removed and replaced with first conductive contacts that touch at least a top surface of any of the first source or drain regions. The first dielectric liner on at least a portion of the top surface of the first source or drain regions would also be removed prior to forming the first conductive contacts.

Method 1400 continues with operation 1416 where sacrificial material is removed from additional selected portions of the source/drain trench between adjacent pairs of dielectric walls. Another mask material may be used to protect the sacrificial material in other portions of the source/drain trench and/or portions of the source/drain trench having source or drain regions. The exposed sacrificial material may be removed using any suitable isotropic etching process to expose the ends of the semiconductor regions along the edges of the source/drain trench. In some embodiments, a lower dielectric region is formed at the bottom of the portions of the source/drain trench where the sacrificial material is removed. The lower dielectric region can include any number of dielectric materials and/or layers and may be provided to isolate the eventual source or drain regions from any portion of the underlying substrate and/or subfin portions.

Method 1400 continues with operation 1418 where second source or drain regions are formed at the ends of the exposed semiconductor regions in the portions of the source/drain trenches where the sacrificial material is removed. Epitaxial growth of the second source or drain regions may occur from the exposed ends of the semiconductor layers. The second source or drain regions may be NMOS source or drain regions (e.g., epitaxial silicon) or PMOS source or drain regions (e.g., epitaxial SiGe). According to some embodiments, the second source or drain regions have the opposite dopant type (n-type or p-type) compared to the first source or drain regions.

According to some embodiments, a second dielectric liner is formed on the second source or drain regions. The second dielectric liner may be deposited using any suitable conformal deposition technique such as CVD, PECVD, or ALD to form at least on the exposed top surfaces of the second source or drain regions. According to some embodiments, the second dielectric liner also forms along one or more side surfaces of the second source or drain regions such that the second dielectric liner forms between the second source or drain regions and the adjacent dielectric walls within the source/drain trench. Due to the deposition process, the second dielectric liner may also form along any exposed sidewalls of the dielectric walls, such as portions of the sidewalls that extend above the second source or drain regions. The second dielectric liner may be any suitable dielectric material, such as silicon nitride. According to some embodiments, some voids may be present within the second dielectric liner between sides of the second source or drain regions and the adjacent dielectric walls.

According to some embodiments, a second dielectric fill may be formed over any of the second source or drain regions within the source/drain trench. In some instances, the second dielectric fill acts as a placeholder and may be later removed and replaced with second conductive contacts that touch at least a top surface of any of the second source or drain regions. The second dielectric liner on at least a portion of the top surface of the second source or drain regions would also be removed prior to forming the second conductive contacts.

### Example System

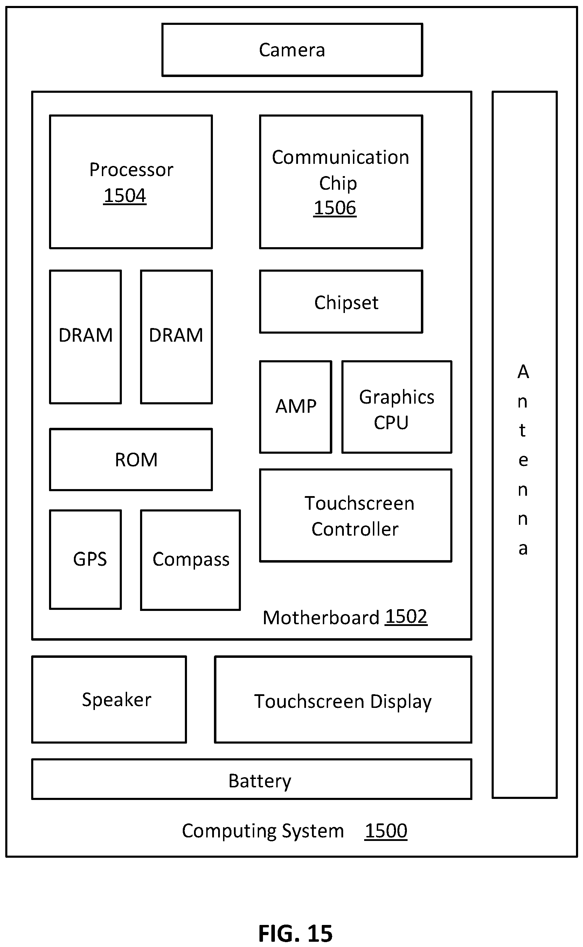

FIG. 15 is an example computing system implemented with one or more of the integrated circuit structures as disclosed herein, in accordance with some embodiments of the present disclosure. As can be seen, the computing system 1500 houses a motherboard 1502. The motherboard 1502 may include a number of components, including, but not limited to, a processor 1504 and at least one communication chip 1506, each of which can be physically and electrically coupled to the motherboard 1502, or otherwise integrated therein. As will be appreciated, the motherboard 1502 may be, for example, any printed circuit board (PCB), whether a main board, a daughterboard mounted on a main board, or the only board of system 1500, etc.

Depending on its applications, computing system 1500 may include one or more other components that may or may not be physically and electrically coupled to the motherboard 1502. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1500 may include one or more integrated circuit structures or devices configured in accordance with an example embodiment (e.g., a module including an integrated circuit device on a substrate, the substrate having one or more semiconductor devices with source or drain regions formed between dielectric walls, as variously provided herein). In some embodiments, multiple functions can be integrated into one or more chips (e.g., for instance, note that the communication chip 1506 can be part of or otherwise integrated into the processor 1504).

The communication chip 1506 enables wireless communications for the transfer of data to and from the computing system 1500. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1506 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1500 may include a plurality of communication chips 1506. For instance, a first communication chip 1506 may be dedicated to shorter range wireless communications such as Wi-Fi and Bluetooth and a second communication chip 1506 may be dedicated to longer range wireless communications such as GPS, EDGE, GPRS, CDMA, WiMAX, LTE, Ev-DO, and others.

The processor 1504 of the computing system 1500 includes an integrated circuit die packaged within the processor 1504. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 1506 also may include an integrated circuit die packaged within the communication chip 1506. In accordance with some such example embodiments, the integrated circuit die of the communication chip includes one or more semiconductor devices as variously described herein. As will be appreciated in light of this disclosure, note that multi-standard wireless capability may be integrated directly into the processor 1504 (e.g., where functionality of any chips 1506 is integrated into processor 1504, rather than having separate communication chips). Further note that processor 1504 may be a chip set having such wireless capability. In short, any number of processor 1504 and/or communication chips 1506 can be used. Likewise, any one chip or chip set can have multiple functions integrated therein.

In various implementations, the computing system 1500 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 1500 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a semiconductor device having a semiconductor region extending in a first direction from a source or drain region, and a gate electrode extending in a second direction over the semiconductor region, a first dielectric wall extending in the first direction through the gate electrode and extending in the first direction adjacent to a first side of the source or drain region, a second dielectric wall extending in the first direction through the gate electrode and extending in the first direction adjacent to a second side of the source or drain region opposite from the first side of the source or drain region, and a dielectric liner on at least a portion of the first side of the source or drain region or the second side of the source or drain region and on at least a portion of a sidewall of the first dielectric wall and at least a portion of a sidewall of the second dielectric wall.

Example 2 includes the integrated circuit of Example 1, further comprising a conductive contact on a top surface of the source or drain region.

Example 3 includes the integrated circuit of Example 1 or 2, wherein the dielectric liner is also on at least a portion of a top surface of the source or drain region.

Example 4 includes the integrated circuit of any one of Examples 1-3, wherein the dielectric liner comprises a low-k dielectric material.

Example 5 includes the integrated circuit of any one of Examples 1-4, wherein the dielectric liner comprises silicon and nitrogen.

Example 6 includes the integrated circuit of any one of Examples 1-5, wherein the source or drain region does not contact any sidewall of the first dielectric wall and second dielectric wall.

Example 7 includes the integrated circuit of any one of Examples 1-6, wherein the semiconductor region comprises a plurality of semiconductor nanoribbons.

Example 8 includes the integrated circuit of Example 7, wherein the plurality of semiconductor nanoribbons comprise germanium, silicon, or a combination thereof.

Example 9 includes the integrated circuit of any one of Examples 1-8, wherein the second direction is substantially perpendicular to the first direction.

Example 10 includes the integrated circuit of any one of Examples 1-9, wherein the first dielectric wall and the second dielectric wall each extend through an entire thickness of the gate electrode.

Example 11 includes the integrated circuit of any one of Examples 1-10, further comprising one or more voids within the dielectric liner adjacent to the first or second side of the source or drain region.

Example 12 is a printed circuit board comprising the integrated circuit of any one of Examples 1-11.

Example 13 is an electronic device that includes a chip package having one or more dies. At least one of the one or more dies includes a semiconductor device having a semiconductor region extending in a first direction from a first source or drain region to a second source or drain region, and a gate electrode extending in a second direction over the semiconductor region, a first dielectric wall extending in the first direction through the gate electrode and extending in the first direction adjacent to a first side of the first source or drain region and adjacent to a first side of the second source or drain region, a second dielectric wall extending in the first direction through the gate electrode and extending in the first direction adjacent to a second side of the first source or drain region opposite from the first side of the first source or drain region and adj acent to a second side of the second source or drain region opposite from the first side of the second source or drain region, and a first dielectric liner on at least a portion of the first source or drain region and a second dielectric liner on at least a portion of the second source or drain region.

Example 14 includes the electronic device of Example 13, wherein the at least one of the one or more dies further comprises a conductive contact on a top surface of the first source or drain region.

Example 15 includes the electronic device of Example 13 or 14, wherein the first dielectric liner is on at least a portion of a top surface of the first source or drain region.

Example 16 includes the electronic device of any one of Examples 13-15, wherein the first and second dielectric liners comprise a low-k dielectric material.

Example 17 includes the electronic device of any one of Examples 13-16, wherein the first and second dielectric liners comprise silicon and nitrogen.

Example 18 includes the electronic device of any one of Examples 13-17, wherein the first source or drain region and the second source or drain region do not contact any sidewall of the first dielectric wall and second dielectric wall.

Example 19 includes the electronic device of any one of Examples 13-18, wherein the semiconductor region comprises a plurality of semiconductor nanoribbons.

Example 20 includes the electronic device of Example 19, wherein the plurality of semiconductor nanoribbons comprise germanium, silicon, or a combination thereof.

Example 21 includes the electronic device of any one of Examples 13-20, wherein the second direction is substantially perpendicular to the first direction.

Example 22 includes the electronic device of any one of Examples 13-21, wherein the first dielectric wall and the second dielectric wall each extend through an entire thickness of the gate electrode.

Example 23 includes the electronic device of any one of Examples 13-22, wherein the first dielectric liner comprises one or more voids adjacent to the first or second side of the first source or drain region.

Example 24 includes the electronic device of any one of Examples 13-23, further comprising a printed circuit board, wherein the chip package is coupled to the printed circuit board.

Example 25 is a method of forming an integrated circuit. The method includes forming a fin comprising semiconductor material, the fin extending above a substrate and extending in a first direction; forming a sacrificial gate structure and spacer structures extending in a second direction over the fin, such that a portion of the fin are not covered by the sacrificial gate structure and spacer structures; forming a recess between adjacent spacer structures by removing the portion of the fin; forming a sacrificial material within the recess between the adjacent spacer structures; replacing the sacrificial gate with a gate structure; forming a first dielectric wall through an entire thickness of the gate structure and through an entire thickness of the sacrificial material, the first dielectric wall extending in the first direction adjacent to a first side of fin; forming a second dielectric wall through an entire thickness of the gate structure and through an entire thickness of the sacrificial material, the second dielectric wall extending in the first direction adj acent to a second side of fin opposite to the first side of the fin; removing the sacrificial material and forming a source or drain region from an exposed end of the semiconductor material within the recess; and forming a dielectric liner on the source or drain region, on a sidewall of the first dielectric wall, and on a sidewall of the second dielectric wall.

Example 26 includes the method of Example 25, wherein the semiconductor material includes an alternating stack of first semiconductor layers and second semiconductor layers, the method further comprising removing the second semiconductor layers to form first suspended nanoribbons from the first semiconductor layers.

Example 27 includes the method of Example 25 or 26, wherein the sacrificial material comprises titanium and nitrogen.

Example 28 includes the method of any one of Examples 25-27, further comprising removing at least a portion of the dielectric liner on a top surface of the source or drain region and forming a conductive contact on the top surface of the source or drain region.

Example 29 includes the method of any one of Examples 25-28, wherein the fin is a first fin, the method comprising forming a second fin comprising semiconductor material, the second fin extending above the substrate and extending in the first direction adjacent to the first fin, and wherein the first dielectric wall extends in the first direction between the first fin and the second fin.

Example 30 is an integrated circuit that includes a first semiconductor device and a second semiconductor device. The first semiconductor device has a first semiconductor region extending in a first direction from a first source or drain region, and a first gate structure extending in a second direction over the first semiconductor region. The second semiconductor device has a second semiconductor region extending in the first direction from a second source or drain region, and a second gate structure extending in the second direction over the second semiconductor region. The first gate structure includes a first gate electrode and a first gate dielectric, and the second gate structure includes a second gate electrode and a second gate dielectric. The second source or drain region is adjacent to the first source or drain region along the second direction. The integrated circuit further includes a dielectric wall extending in the first direction between and contacting both the first gate electrode and the second gate electrode and extending in the first direction between the first source or drain region and the second source or drain region. A first dielectric liner is on at least a portion of the first source or drain region and on at least a portion of a first sidewall of the dielectric wall, and a second dielectric liner on at least a portion of the second source or drain region and on at least a portion of a second sidewall of the dielectric wall.

Example 31 includes the integrated circuit of Example 30, further comprising a first conductive contact on a top surface of the first source or drain region and a second conductive contact on a top surface of the second source or drain region.

Example 32 includes the integrated circuit of Example 30 or 31, wherein the first dielectric liner is also on at least a portion of a top surface of the first source or drain region and/or the second dielectric liner is also on at least a portion of a top surface of the second source or drain region.

Example 33 includes the integrated circuit of any one of Examples 30-32, wherein the first and second dielectric liners comprise a low-k dielectric material.

Example 34 includes the integrated circuit of any one of Examples 30-33, wherein the first and second dielectric liners comprise silicon and nitrogen.

Example 35 includes the integrated circuit of any one of Examples 30-34, wherein the first source or drain region does not contact any portion of the first sidewall of the dielectric wall and/or the second source or drain region does not contact any portion of the second sidewall of the dielectric wall.

Example 36 includes the integrated circuit of any one of Examples 30-35, wherein the first semiconductor region comprises a plurality of first semiconductor nanoribbons and the second semiconductor region comprises a plurality of second semiconductor nanoribbons.

Example 37 includes the integrated circuit of Example 36, wherein the plurality of semiconductor nanoribbons comprise germanium, silicon, or a combination thereof.

Example 38 includes the integrated circuit of any one of Examples 30-37, wherein the second direction is substantially perpendicular to the first direction.

Example 39 includes the integrated circuit of any one of Examples 30-38, wherein the dielectric wall extends through an entire thickness of the first gate electrode and second gate electrode.

Example 40 includes the integrated circuit of any one of Examples 30-39, further comprising one or more voids within the first dielectric liner and/or the second dielectric liner.

Example 41 is a printed circuit board comprising the integrated circuit of any one of Examples 30-40.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a semiconductor device having a semiconductor region extending in a first direction from a source or drain region, and a gate electrode extending in a second direction over the semiconductor region;
a first dielectric wall extending in the first direction through the gate electrode and extending in the first direction adjacent to a first side of the source or drain region;
a second dielectric wall extending in the first direction through the gate electrode and extending in the first direction adjacent to a second side of the source or drain region opposite from the first side of the source or drain region; and
a dielectric liner on at least a portion of the first side of the source or drain region or the second side of the source or drain region and on at least a portion of a sidewall of the first dielectric wall and at least a portion of a sidewall of the second dielectric wall.

2. The integrated circuit of claim 1, further comprising a conductive contact on a top surface of the source or drain region.

3. The integrated circuit of claim 1 or 2, wherein the dielectric liner is also on at least a portion of a top surface of the source or drain region.

4. The integrated circuit of any one of claims 1 through 3, wherein the dielectric liner comprises a low-k dielectric material.

5. The integrated circuit of any one of claims 1 through 4, wherein the dielectric liner comprises silicon and nitrogen.

6. The integrated circuit of any one of claims 1 through 5, wherein the source or drain region does not contact any sidewall of the first dielectric wall and second dielectric wall.

7. The integrated circuit of any one of claims 1 through 6, wherein the semiconductor region comprises a plurality of semiconductor nanoribbons.

8. The integrated circuit of claim 7, wherein the plurality of semiconductor nanoribbons comprise germanium, silicon, or a combination thereof.

9. The integrated circuit of any one of claims 1 through 8, wherein the second direction is substantially perpendicular to the first direction.

10. The integrated circuit of any one of claims 1 through 9, wherein the first dielectric wall and the second dielectric wall each extend through an entire thickness of the gate electrode.

11. The integrated circuit of any one of claims 1 through 10, further comprising one or more voids within the dielectric liner adjacent to the first or second side of the source or drain region.

12. A printed circuit board comprising the integrated circuit of any one of claims 1-11.

13. A method of forming an integrated circuit, the method comprising:
forming a fin comprising semiconductor material, the fin extending above a substrate and extending in a first direction;
forming a sacrificial gate structure and spacer structures extending in a second direction over the fin, such that a portion of the fin are not covered by the sacrificial gate structure and spacer structures;
forming a recess between adjacent spacer structures by removing the portion of the fin;
forming a sacrificial material within the recess between the adjacent spacer structures;
replacing the sacrificial gate with a gate structure;
forming a first dielectric wall through an entire thickness of the gate structure and through an entire thickness of the sacrificial material, the first dielectric wall extending in the first direction adjacent to a first side of fin;
forming a second dielectric wall through an entire thickness of the gate structure and through an entire thickness of the sacrificial material, the second dielectric wall extending in the first direction adjacent to a second side of fin opposite to the first side of the fin;
removing the sacrificial material and forming a source or drain region from an exposed end of the semiconductor material within the recess; and
forming a dielectric liner on the source or drain region, on a sidewall of the first dielectric wall, and on a sidewall of the second dielectric wall.

14. The method of claim 13, wherein the semiconductor material includes an alternating stack of first semiconductor layers and second semiconductor layers, the method further comprising removing the second semiconductor layers to form first suspended nanoribbons from the first semiconductor layers.

15. The method of claim 13 or 14, further comprising:
removing at least a portion of the dielectric liner on a top surface of the source or
drain region and forming a conductive contact on the top surface of the source or
drain region.
